# Europäisches Patentamt
# European Patent Office
# Office européen des brevets

(19)

(11) Numéro de publication: **0 154 570**
**B1**

(12) # FASCICULE DE BREVET EUROPÉEN

(45) Date de publication du fascicule du brevet:
**08.06.88**

(51) Int. Cl.⁴: **H 05 K 5/00**, H 05 K 7/14

(21) Numéro de dépôt: **85400104.7**

(22) Date de dépôt: **23.01.85**

(54) **Structure alvéolaire porte-cartes électroniques.**

(30) Priorité: **08.02.84 FR 8401916**

(43) Date de publication de la demande:
**11.09.85 Bulletin 85/37**

(45) Mention de la délivrance du brevet:
**08.06.88 Bulletin 88/23**

(84) Etats contractants désignés:
**BE DE GB IT NL SE**

(56) Documents cité:
**EP-A-0 018 191**
**GB-A-2 021 869**
**US-A-3 603 845**

(73) Titulaire: **LA TELEMECANIQUE ELECTRIQUE, 33 bis, avenue du Maréchal Joffre, F-92000 Nanterre (FR)**

(72) Inventeur: **Lerude, Gérard, Chemin du Puy La Vigie Parc Maré Polis, F-06600 Antibes (FR)**
Inventeur: **Roux, Christine, Quartier Le Collet Opio, F-06650 Le Rouret (FR)**

(74) Mandataire: **Marquer, Francis, CABINET MOUTARD 35, avenue Victor Hugo Résidence Champfleury, F-78180 Voisins- le- Bretonneux (FR)**

EP 0 154 570 B1

LIBER, STOCKHOLM 1988

## Description

La présente invention concerne une structure alvéolaire porte-cartes électroniques obtenue par juxtaposition et assemblage de cellules modulaires de support et de protection par exemple du type de celle décrite dans la demande EP-A-0 155 856, pouvant chacune recevoir une carte.

D'une manière générale, on sait qu'il est connu de réaliser des dispositifs électroniques multicartes par juxtaposition et, le cas échéant, assemblage d'alvéoles élémentaires contenant chacune une carte électronique.

Ces dispositifs font habituellement intervenir une embase rigide contenant des connecteurs arrière et un câblage de connexion inter-cartes, et portant les alvéoles contenant les cartes. Cette embase assure en outre l'alignement et la fixation des alvéoles. Il est clair que la longueur hors tout de ces dispositifs est nécessairement celle de l'embase, quel que soit le nombre d'alvéoles utilisé.

On a également proposé, notamment par le brevet US-A-3 603 845, d'assurer la fixation des cellules au moyen d'éléments de support et de fixation réalisés notamment à l'aide de profilés en forme de cornières.

Un autre mode d'assemblage connu consiste à juxtaposer des boîtiers fermés complets logeant chacun une carte électronique et un tronçon de câblage inter-cartes par exemple un tronçon de bus compris entre un connecteur mâle et un connecteur femelle, respectivement solidaires de chaque flan du boîtier. La longueur hors tout d'un tel dispositif correspond certes à sa longueur utile, mais les boîtiers doivent être conçus avec des cotes précises pour garantir de bonnes conditions d'interconnexion et d'assemblagle ; cette précision associée aux contraintes de câblage du tronçon de bus contenu dans chaque boîtier, grève le coût des pièces constitutives du dispositif et augmente son temps de montage.

L'invention a notamment pour but de remédier à ces inconvénients et propose une structure alvéolaire réalisée au moyen de cellules modulaires conçues de manière à pouvoir facilement s'assembler les unes aux autres sans avoir à utiliser un quelconque outillage et à faciliter les connexions.

Elle a également pour but de réduire autant que possible le nombre de pièces intervenant dans la structure et leur précision tout en éliminant les jeux résiduels d'assemblage.

Elle a en outre pour but d'améliorer la commodité de fixation, d'utilisation et d'échange des cartes utilisées dans cette structure.

L'invention propose une structure alvéolaire porte-cartes électroniques réalisée par assemblage d'au moins deux cellules modulaires de support et de protection de cartes électroniques, caractérisée en ce que lesdites cellules modulaires comprennent chacune, d'une part, un élément plat ou flan présentant deux bordures latérales parallèles, une bordure antérieure et une bordure postérieure et, d'autre part, s'étendant perpendiculairement audit flan, à partir de sa bordure postérieure et de ses deux bordures latérales, respectivement un fond et deux côtés latéraux munis de moyens de guidage des cartes formant deux glissières latérales respectives, parallèles au flan, et en ce que lesdits côtés latéraux de la cellule modulaire comprennent chacun une première bordure longitudinale adjacente audit flan et une deuxième bordure longitudinale opposée à la première, ces deux bordures longitudinales comprenant des moyens de fixation respectivement complémentaires, de manière à permettre la fixation de deux cellules modulaires adjacentes par assemblage des premières bordures longitudinales des côtés latéraux de la première cellule sur les deuxièmes bordures longitudinales des côtés latéraux de la deuxième cellule modulaire.

Selon ce mode d'assemblage, le flan de la première cellule vient refermer la face ouverte de la deuxième cellule, de sorte que l'on obtient ainsi un alvéole ouvert uniquement sur son côté antérieur, ouverture par laquelle s'effectue l'introduction de la carte.

Il est clair que l'assemblage d'une troisième cellule modulaire sur les deux premières permet d'obtenir un deuxième alvéole et ainsi de suite. Il est ainsi possible d'obtenir une structure alvéolaire comprenant le nombre d'alvéoles désiré.

Toutefois, il s'avère que dans cette structure, l'une des deux cellules modulaires d'extrémité demeurera ouverte.

C'est la raison pour laquelle l'invention de préférence prévoit en outre une embase de tête comprenant au moins une face plane équipée de moyens de fixation complémentaires à ceux prévus sur les susdites deuxièmes bordures longitudinales des cellules modulaires. Ainsi, cette embase de tête peut venir refermer la cellule modulaire d'extrémité demeurée ouverte. Bien entendu, cette embase de tête peut présenter de multiples formes. Elle peut par exemple consister en un boîtier pouvant contenir des équipements électroniques, connectables aux cartes logées dans les cellules modulaires. Elle peut également présenter une forme similaire à celle des cellules modulaires et comprendre alors, d'une façon analogue, une paroi plane présentant deux bordures latérales parallèles, une bordure antérieure et une bordure postérieure et, d'autre part, s'étendant perpendiculairement à ladite paroi, à partir de sa bordure postérieure et de ses deux bordures latérales, respectivement un fond et deux côtés latéraux. Dans ce cas, les bordures longitudinales de ces côtés latéraux, opposées à ladite paroi, sont munies de moyens de fixation complémentaires de ceux prévus sur la deuxième bordure des côtés latéraux des cellules modulaires.

Par ailleurs, le fond des susdites cellules modulaires et éventuellement de l'embase de tête peut avantageusement présenter au moins une fenêtre de passage pour un connecteur arrière enfichable sur les connexions arrière de la carte. Dans ce cas, la face arrière du fond de la cellule modulaire et éventuellement de l'embase de tête présente au droit de ladite fenêtre des surfaces d'appui pour des faces correspondantes du connecteur ainsi que des moyens d'immobilisation dudit connecteur.

Le fond des cellules modulaires et de l'embase de tête peut en outre comprendre une conformation permettant sa fixation sur un élément de support tel qu'un rail normalisé ainsi que des guides permettant de recevoir un cliquet coulissant pour le verrouillage dudit fond sur ledit élément de support. Le fond peut également comprendre une échancrure disposée de manière à former, lorsque deux cellules se trouvent assemblées, un évidement pouvant servir à la fixation arrière de la structure sur un élément de support.

Selon un mode particulier de réalisation de l'invention, les susdites cellules modulaires sont réalisées en deux parties, à savoir :
- un élément cellulaire réalisé en matériau isolant, de préférence en matière plastique moulée et comprenant, d'une part, l'élément plat ou flan présentant les deux bordures latérales parallèles, la bordure antérieure et la bordure postérieure et, d'autre part, s'étendant perpendiculairement audit flan, à partir de sa bordure postérieure et de ses deux bordures latérales, respectivement la fond et les deux côtés latéraux munis de moyens de guidage des cartes formant deux glissières latérales respectives, parallèles au flan, et
- un blindage métallique de section en forme de U, dont l'âme vient au moins en partie recouvrir le flan de l'élément cellulaire et dont les deux ailes viennent en retour contre les deux susdits côtés latéraux.

Dans ce cas, les susdits moyens de fixation équipant les côtés latéraux de la cellule modulaire sont prévus sur les ailes du blindage. Avantageusement, les bordures libres des ailes du blindage peuvent comprendre des portions repliées vers l'intérieur pour permettre un montage par coulissement de l'élément cellulaire à l'intérieur du blindage. Les susdits moyens de fixation peuvent alors consister en des crochets en saillie sur les bord libres des ailes du blindage et en des découpes correspondantes prévues dans la zone de pliage située entre l'âme et les ailes dudit blindage, de telle manière que les susdits crochets d'une cellule modulaire puissent venir s'engager dans les découpes d'une cellule modulaire adjacente axialement décalée, le verrouillage étant ensuite obtenu par une translation axiale de centrage de l'une des cellules par rapport à l'autre.

De préférence l'invention prévoit en outre des moyens permettant le centrage par encliquetage de l'élément alvéolaire dans le blindage ainsi que des moyens permettant le centrage des éléments alvéolaires de la structure, les uns par rapport aux autres.

Ainsi, selon un mode d'exécution de l'invention, les moyens de centrage des éléments alvéolaires par rapport à leur blindage comprennent des ouvertures constituant des prises pour des cliquets prévus en des emplacements correspondants sur le flan de l'élément cellulaire. Les éléments de centrage des éléments alvéolaires de la structure, les uns par rapport aux autres, comprennent des éléments mâles prévus sur l'une des bordures longitudinales du fond qui viennent s'emboîter dans des éléments femelle prévus sur l'autre bordure longitudinale du fond.

La disposition des éléments de centrage et des moyens de fixation équipant le blindage peut alors être prévue de manière à permettre un assemblage de la structure selon les étapes suivantes :
1) l'introduction partielle, par coulissement, de l'élément cellulaire d'une première cellule modulaire dans son blindage,
2) le centrage de cet élément cellulaire par rapport à l'élément cellulaire d'une deuxième cellule modulaire adjacente déjà assemblée avec engagement des moyens de fixation du blindage de la première cellule dans les moyens de fixation correspondants du blindage de la deuxième cellule,
3) la translation axiale du blindage de la première cellule jusqu'à obtention à la fois de son centrage par rapport à son propre élément cellulaire par lesdits moyens d'autocentrage et de son verrouillage sur le blindage de la deuxième cellule modulaire.

Bien entendu, l'assemblage des cellules modulaires sur l'embase de tête peut être réalisé d'une façon analogue étant entendu que, dans ce cas, le fond de l'embase peut également comprendre des éléments de centrage complémentaires de ceux équipant d'un côté le fond des structures alvéolaires des cellules modulaires.

Les avantages ainsi que les particularités de l'invention apparaîtront clairement à la lumière de la description ci-après d'un mode d'exécution de l'invention donné à titre d'exemple non limitatif, avec référence aux dessins annexés dans lesquels :

La figure 1 représente en perspective un mode de réalisation d'une structure alvéolaire à trois alvéoles réalisée à l'aide de cellules guide-carte selon l'invention.

La figure 2 représente une partie du même dispositif en perspective.

La figure 3 montre, en perspective, un élément cellulaire guide-carte utilisé dans la structure représentée figure 1.

La figure 4 montre la face arrière du fond du même élément cellulaire.

La figure 5 représente un détail de la tranche d'une carte utilisable dans une cellule modulaire selon l'invention.

La figure 6 est une vue en perspective arrière d'une embase de tête.

La figure 7 représente, en perspective avant, le blindage d'une cellule modulaire.

Les figures 8 et 9 montrent un ensemble de connexion arrière et une lame d'immobilisation de cet ensemble.

La figure 10 représente, en perspective arrière, une variante de réalisation de l'embase de tête.

La figure 11 est une vue en coupe partielle d'une structure alvéolaire au droit des fenêtres de connexion.

La structure alvéolaire porte-cartes électroniques 100 représentée sur les figures comprend une embase de tête 110 et plusieurs cellules modulaires 130 munies chacune d'un élément cellulaire guide-carte isolant 300, chaque élément cellulaire 300 étant revêtu d'un blindage métallique 200 et étant apte à recevoir une carte électronique 400.

Les cellules modulaires 130 sont assemblées entre elles pour constituer un ensemble rigide multicartes, par exemple un automate programmable, cet ensemble étant fixé latéralement ou par sa partie arrière à un support, par exemple à un profilé normalisé 140 ou à une platine. Chaque cellule modulaire reçoit sur sa face avant un bornier 150.

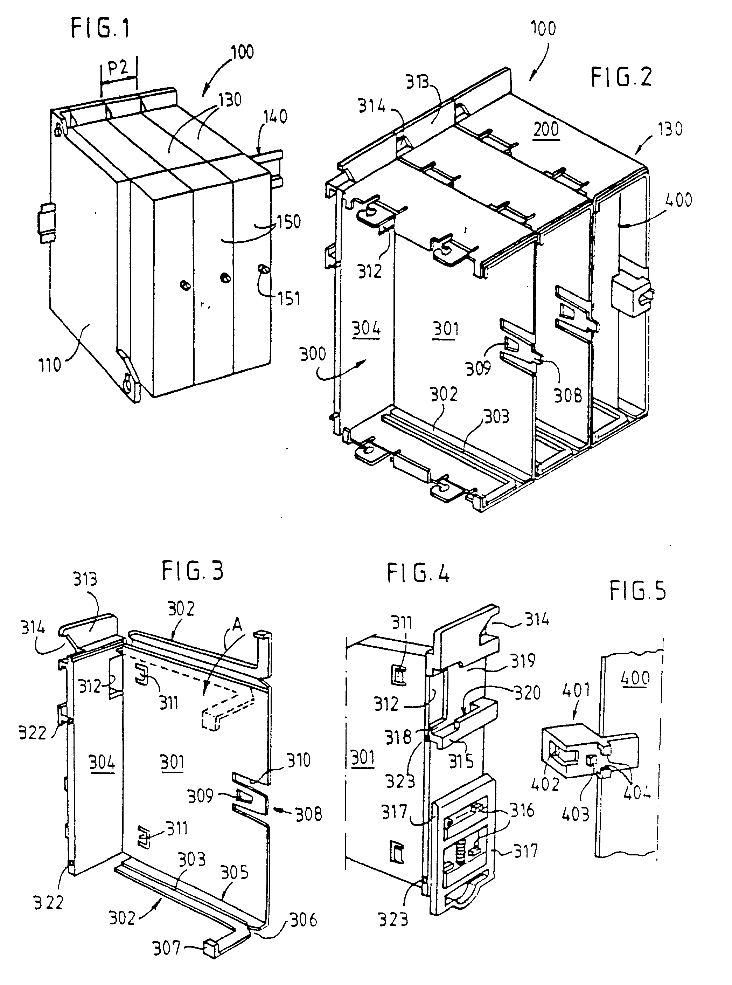

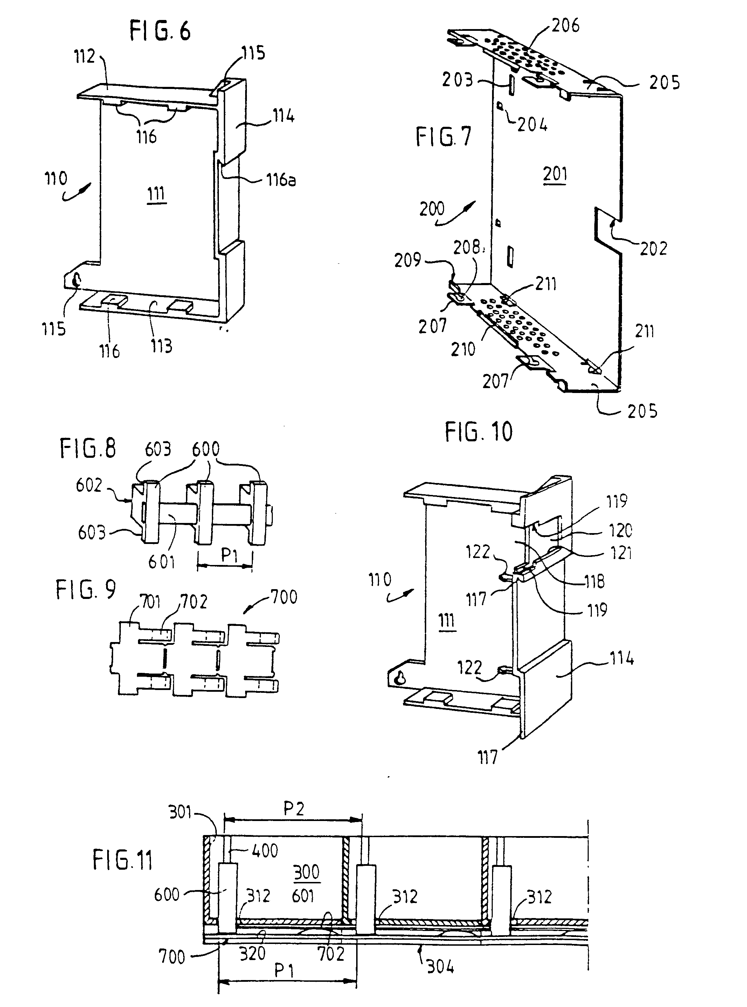

L'élément cellulaire 300 est moulé d'une pièce pour prendre la forme visible figure 2 ; il est maintenu par emboîtement et protégé dans le blindage métallique 200 (figure 7) et constitue, en même temps qu'un logement pour la carte 400, un moyen de fixation de la carte et de son bornier avant 150 et un moyen de positionnement mutuel de la carte et de son connecteur arrière 600.

L'élément cellulaire 300 comporte (figures 2 à 4) un élément plat ou flan 301 de protection de la face soudure de la carte électronique, deux côtés latéraux ou rabats en L, 302 munis de glissières 303 pour la carte, ainsi qu'un fond 304 destiné à former un socle arrière de fixation. Les rabats 302 sont reliés au flan 301 par des lignes d'articulation 305 formant charnières, tandis que les glissières 303 débouchent vers l'avant par des ouvertures en V, 306 ; la petite branche du L de chaque rabat présente un redan 307.

Les rabats 302 sont pliés comme le montre la flèche A de la figure 3 pour venir occuper la position indiquée en tirets pour le rabat supérieur et en traits pleins pour le rabat inférieur. Il est prévu un encliquetage ou autre moyen pour fixer les rabats 302 sur le fond 304.

Le flan 301 comprend de plus une languette élastique 308 munie d'un évidement 309, la languette et l'évidement ayant une forme en V convergente vers l'avant, la languette étant située dans un dégagement frontal 310 prévu dans la tranche du flan.

Dans la partie postérieure du flan sont ménagés des cliquets élastiques 311 dont le rôle sera expliqué plus loin.

Le fond ou socle 304 de la cellule guide-carte 300 présente une fenêtre 312 de libre passage pour le connecteur 600 associé à la cellule, cette fenêtre présentant une largeur supérieure à celle du connecteur pour permettre un débattement latéral de celui-ci. Le fond 304 comprend de plus une oreille supérieure 313 à encoche latérale de fixation 314, ainsi qu'à l'arrière (figure 4) une saillie rainurée 315 d'accrochage sur rail normalisé et des guides 316 permettant de recevoir un cliquet coulissant 317 de verrouillage de l'élément cellulaire 300 sur le rail. L'élément cellulaire 300 peut ainsi être fixé directement soit sur un rail, soit sur un support quelconque au moyen d'une vis engagée dans l'évidement 314 fermé par l'oreille d'une cellule modulaire voisine ou par l'embase (figure 2).

Sur la face arrière du fond 304, l'élément cellulaire 300 présente au droit de la fenêtre 312 des faces d'appui 318 pour des faces coopérantes du connecteur 600 et un logement échancré 319 définissant des encoches 320 afin de recevoir des moyens d'immobilisation du connecteur qui seront décrits plus loin.

Des éléments complémentaires de centrage, à savoir des pions 322 et des trous 323, sont prévus respectivement de part et d'autre du fond 304 sur les faces latérales de celui-ci pour permettre l'assemblage entre cellules modulaires ou entre cellule modulaire et embase.

Le blindage métallique 200 visible sur les figures 2 et 7 a une section en U dont l'âme 201 présente une ouverture 202 correspondant sensiblement au dégagement 310 prévu dans la cloison latérale 301 de l'élément cellulaire associé, ainsi que des ouvertures 203 et 204: Les ouvertures 203 constituent des prises des cliquets 311 de l'élément cellulaire 300, tandis que les ouvertures 204 reçoivent, le cas échéant, les cliquets de l'embase. Les ailes 205 du blindage en U présentent des perforations régulières 206, des pattes 207 à fentes 208 formant crochets et' des plis 209, 210 de raidissement et de butée notamment pour le redan 307 du rabat en L de l'élément cellulaire.

Des fentes 211 sont ménagées par crevé aux plis du U, tandis que les pattes 207 sont situées dans des plans décalés vers l'intérieur par rapport aux plans des ailes 205 du blindage ; on assemble donc deux cellules modulaires adjacentes par introduction des pattes 207 du blindage de l'une dans les fentes 211 des pattes du blindage de l'autre puis glissement perpendiculaire relatif des blindages pour engager les fentes 208 de l'un sur l'âme 201 de l'autre.

Sur la tranche antérieure de chaque carte 400 est disposé un bloc de fixation 401 (figure 5) muni vers l'avant d'un écrou prisonnier ou d'un orifice taraudé 402 pour la fixation d'une vis 151 prévue sur le bornier associé 150, et muni latéralement d'un cliquet ou autre élément de verrouillage 403 conçu pour coopérer avec l'évidement 309 de la languette élastique 308 de l'élément cellulaire.

Deux saillies de guidage 404 sont prévues sur le côté du bloc 401 pour guider la languette élastique 308 lorsqu'on introduit la carte dans la cellule modulaire. La longueur de l'évidement 309 est telle que celui-ci reçoit le cliquet 403 avec jeu, la mise en butée de la carte s'obtenant grâce à la vis 151 du bornier 150 comme il sera décrit par la suite.

L'embase de tête 110 en métal moulé est agencée pour loger l'alimentation du dispositif multicartes et, quand ce dispositif est un automate, pour loger l'unité centrale de ce dernier ; elle présente une paroi plane 111, deux côtés latéraux 112, 113 et un fond 114. La paroi plane 111 présente des orifices 115 de fixation utilisables dans le cas d'une pose de la structure alvéolaire sur un support latéral. Chaque côté latéral 112, 113 comprend deux fourreaux 116 agencés pour l'accrochage des pattes de fixation 207 du blindage de la cellule modulaire mitoyenne. Le fond 114 présente des moyens 116a d'engagement et/ou de fixation par vissage ou encliquetage sur un support ; la tranche de ce fond est munie d'éléments de centrage 117 du côté de la cellule modulaire à fixer.

Dans le mode de réalisation de la figure 10, l'embase métallique de tête doit recevoir, outre une alimentation régulée, une unité centrale d'automate ; en vue d'assurer la connexion d'une carte non dessinée, elle présente une fenêtre 118 de passage pour un connecteur 600, des faces d'appui 119 pour les faces correspondantes du connecteur et un logement à échancrure 120 définissant des encoches 121 pour des moyens d'immobilisation du connecteur ; les éléments 119, 121 de l'embase ont des fonctions similaires à ceux 318, 320 des faces arrière des cellules modulaires.

Des cliquets 122 sont disposés pour coopérer avec les ouvertures 203 du blindage 200 complétant cette embase.

L'ensemble de connexion représenté sur les figures 8 et 9 regroupe les connecteurs 600 sur un même bus multiconducteur à nappe ou à câble plat 601, le pas minimum P1 entre connecteurs étant supérieur au pas P2 maximum des alvéoles. Chaque connecteur a une forme de T et présente une face antérieure de connexion 602 et sur les ailes du T des faces antérieures d'appui 603 agencées pour coopérer avec les faces 119 de l'embase. Un organe de fixation et de blindage 700 (figure 9) associé à l'ensemble de connexion comprend une lame de tôle découpée et mise en forme de manière à présenter des saillies latérales 701 et des doigts de pression 702, cette lame servant à bloquer les connecteurs après enfichage de ceux-ci sur les cartes.

Le dispositif décrit s'assemble de la manière suivante. L'élément cellulaire guide-carte 300 de chaque alvéole est moulé et replié comme déjà décrit, puis emboîté dans un blindage 200, les cliquets 311 de l'élément cellulaire n'étant pas encore engagés dans les ouvertures 203 du blindage ; les pattes 207 du blindage dépassent de la cellule. La cellule modulaire de base est alors assemblée à l'embase 110 par engagement des pions de centrage 322 dans les trous correspondants 117 de l'embase, puis par poussée du blindage pour en provoquer la translation vers l'arrière jusqu'à encliquetage des pattes 207 dans les fourreaux 116 et butée du blindage sur le fond 304 de la cellule guide-carte;

il convient de noter qu'au cours de la translation du blindage, les cliquets 311 s'engagent dans les ouvertures 203 pour empêcher désormais tout mouvement relatif de l'élément cellulaire par rapport au blindage.

La deuxième cellule modulaire est assemblée de même à la première et la troisième à la deuxième. La structure est donc extérieurement résistante et rigide grâce à l'encliquetage des blindages ce qui assure leur liaison électrique, tout en assurant intérieurement une souplesse d'introduction et de connexion des cartes électroniques. Il découle du mode d'assemblage décrit que le nombre de cellules modulaires constituant une même structure n'est pas limité. On introduit dans chaque cellule modulaire 130 la carte électronique correspondante 400 par glissement de la carte dans les glissières 303 ; en fin d'introduction, l'extrémité de la languette 308 de l'élément cellulaire s'engage dans les saillies de guidage 404 du bloc 401 solidaire de la carte et le cliquet 403 pénètre dans l'évidement 309 en V de la languette, la longueur de l'évidement laissant subsister une certaine liberté de translation de la carte.

Le bornier 150 est alors mis en place sur la cellule modulaire 130 et l'on fait tourner sa vis de fixation 151 dans l'écrou prisonnier 402 du bloc 401 ; le bornier prend appui sur la face avant de la cellule 130 et le vissage de la vis 151 a dès lors pour effet de tirer vers l'avant la carte 400 jusqu'à ce que le cliquet 403 bute sur les côtés du V de l'évidement 309, ce qui centre et immobilise la carte par rapport à sa cellule de réception.

L'ensemble de connexion comprenant le câble plat et les trois connecteurs 600 est ensuite approché de la face arrière de la structure modulaire et les connecteurs sont introduits par les fenêtres 312 des cellules modulaires et éventuellement la fenêtre 118 de l'embase (dans le mode de réalisation de la figure 10) et enfichés sur les zones encartables ou les connecteurs arrière des cartes 400, jusqu'à prise d'appui des faces 603 des connecteurs sur les faces 318, 119 des cellules modulaires ou de l'embase.

La lame 700 est mise en place sur le dos des connecteurs et ses saillies 701 sont engagées dans le logement à échancrures 319, 120 et les doigts de pression 702 prenant appui sur la face arrière 603 de chaque connecteur 600. Il s'ensuit que la lame de blindage immobilise chaque connecteur 600 dans sa position d'autocentrage par rapport à la carte préalablement immobilisée et donc l'élément cellulaire correspondant.

Il résulte de la description ci-dessus que l'élément cellulaire 300, rendu rigide par l'adjonction du blindage correspondant 200, joue le rôle de référence de position à la fois pour la carte 400 via les glissières 303 et l'évidement d'encliquetage 309 pour le bornier 150 via la vis 151, l'écrou prisonnier 402 et l'encliquetage 309, 403, pour le bornier arrière via la carte 400 et les faces d'appui 318. L'autocentrage des connecteurs arrière sur les cartes déjà immobilisées élimine les contraintes habituelles d'alignement des connecteurs par rapport aux éléments cellulaires vides.

L'échange d'une carte 400 défectueuse s'effectue par dévissage de la vis 151 du bornier 150, débrochage du bornier restant lié à la cellule modulaire par une lanière de maintien, déblocage de la carte par l'écartement de la languette 308 puis extraction de la carte de préférence par prise du bloc 401. La carte de remplacement se glisse dans les glissières 303, se connecte en fin de course sur le connecteur arrière 600 se fixe comme précédemment par l'encliquetage 309, 403 et se verrouille après remise en place du bornier 150 par le vissage de la vis 151.

## Revendications

1. Structure alvéolaire porte-cartes électroniques réalisée par assemblage d'au moins deux cellules modulaires de support et de protection de cartes électroniques,
   caractérisée en ce que lesdites cellules modulaires comprennent chacune, d'une part, un élément plat ou flan (301) présentant deux bordures latérales parallèles, une bordure antérieure et une bordure postérieure et, d'autre part, s'étendant perpendiculairement audit flan, à partir de sa bordure postérieure et de ses deux bordures latérales, respectivement un fond (304) et deux côtés latéraux (302, 205) munis de moyens de guidage des cartes formant deux glissières latérales respectives (303), parallèles au flan (301), et
   en ce que lesdits côtés latéraux (302) de la cellule modulaire comprennent chacun une première bordure longitudinale adjacente audit flan et une deuxième bordure longitudinale opposée à la première, ces deux bordures longitudinales comprenant des moyens de fixation (207, 211) respectivement complémentaires, de manière à permettre la fixation de deux cellules modulaires adjacentes par assemblage des premières bordures longitudinales des côtés latéraux (302, 205) de la première cellule sur les deuxièmes bordures longitudinales des côtés latéraux de la deuxième cellule modulaire.

2. Structure selon la revendication 1,
   caractérisée en ce qu'elle comprend en outre une embase de tête (110) comprenant au moins une face plane équipée de moyens de fixation complémentaires (116) de ceux prévus sur les susdites deuxièmes bordures longitudinales des côtés latéraux (302, 205) des cellules modulaires.

3. Structure selon la revendication 2,
   caractérisée en ce que la susdite embase de tête (110) consiste en un boîtier pouvant contenir des équipements électroniques connectables aux cartes logées dans les cellules modulaires.

4. Structure selon la revendication 2,
   caractérisée en ce que la susdite embase comprend une paroi plane (111) présentant deux bordures latérales parallèles, une bordure antérieure et une bordure postérieure et, d'autre part, s'étendant perpendiculairement à ladite paroi (111), à partir de sa bordure postérieure et de ses deux bordures latérales, respectivement un fond (114) et deux côtés latéraux (112, 113), et
   en ce que les bordures latérales desdits côtés latéraux de l'emvase (112, 113) qui sont opposées à ladite paroi (111) sont munies de moyens de fixation complémentaires (116) de ceux (207) prévus sur la susdite deuxième bordure des côtés latéraux (302, 205) des cellules modulaires.

5. Structure selon l'une des revendications précédentes,
   caractérisée en ce que le fond (306) des susdites cellules modulaires présente au moins une fenêtre (312) de passage pour un connecteur arrière enfichable (600) sur les connexions arrière de la carte.

6. Structure selon la revendication 5,
   caractérisée en ce que la face arrière du fond des susdites cellules modulaires présente au droit de la fenêtre (312) des surfaces d'appui pour des faces correspondantes du connecteur (600), ainsi que des moyens d'immobilisation dudit connecteur (600).

7. Structure selon l'une des revendications 5 et 6,
   caractérisée en ce que les fenêtres de passage (312, 118) ménagées dans le fond (304) ont une largeur et une hauteur supérieures à celles des connecteurs arrière (600), et en ce que les susdits moyens d'immobilisation sont conçus pour immobiliser latéralement le connecteur (600) après enfichage de celui-ci sur la carte (400).

8. Structure selon l'une des revendications 6 et 7,
   caractérisée en ce que les susdits moyens d'immobilisation sont constitués par une lame élastique (700) de pression susceptible d'être engagée dans un logement à échancrure (319, 320) de la face arrière de la cellule.

9. Structure selon l'une des revendications 5 à 8,
   caractérisée en ce que les connecteurs arrière (600) sont montés sur un même bus plat multiconducteur (601), le pas de montage des connecteurs sur le bus étant supérieur au pas maximal des cartes des cellules adjacentes.

10. Structure selon l'une des revendications précédentes,
    caractérisée en ce que les susdites cellules modulaires (130) sont réalisées en deux parties, à savoir :
    - une première partie consistant en un élément cellulaire (300) réalisé en un matériau isolant comprenant l'élément plat ou le flan (301) présentant les deux bordures latérales parallèles, la bordure antérieure et la bordure postérieure et, d'autre part, s'étendant perpendiculairement audit flan à partir de sa bordure postérieure et de ses deux bordures latérales, respectivement le fond (304) et les deux côtés latéraux (302) munis de moyens de guidage des cartes formant les deux glissières latérales respectives (303) parallèles au flan (301), et

- un blindage métallique (200) de section en forme de U dont l'âme (201) vient au moins recouvrir le flan (301) de l'élément cellulaire (300) et dont les deux ailes (205) viennent en retour contre les deux susdits côtés latéraux (302).

11. Structure selon la revendication 10, caractérisée en ce que les moyens de fixation 207, 211) èquipant les côtés latéraux de la cellule modulaire sont prévus sur les ailes (205) du blindage (200) et assurent la liaison électrique entre lesdits blindages (200).

12. Structure selon l'une des revendications 10 et 11, caractérisée en ce que les bordures libres des ailes (205) du blindage (200) comprennent des portions repliées vers l'intérieur (210) pour permettre un montage par coulissement de l'élément cellulaire à l'intérieur du blindage.

13. Structure selon l'une des revendications 10 à 12, caractérisée en ce que les susdits moyens de fixation consistent en des crochets (207) en saillie sur les bords libres des ailes (205) du blindage (200) et en des découpes correspondantes (211) prévues dans la zone de pliage située entre l'âme (201) et les ailes (205) dudit blindage, de telle manière que les crochets (207) d'une cellule modulaire puissent venir s'engager dans les découpes d'une cellule modulaire adjacente axialement décalée, le verrouillage étant ensuite effectué par une translation axiale de centrage de l'une des cellules par rapport à l'autre.

14. Structure selon l'une des revendications 10 à 13, caractérisée en ce que les susdites cellules modulaires comprennent en outre des moyens permettant le centrage des éléments cellulaires (300) les uns par rapport aux autres ainsi que des moyens permettant un autocentrage des éléments cellulaires (300) dans leurs blindages (200) respectifs.

15. Structure selon la revendication 14, caractérisée en ce que les moyens permettant l'autocentrage des éléments cellulaires (300) dans leurs blindages (200) respectifs comprennent des ouvertures (203, 204) constituant des prises pour des cliquets (311) prévus en des emplacements correspondants sur le flan de l'élément cellulaire.

16. Structure selon la revendication 14, caractérisée en ce que les moyens permettant le centrage des éléments cellulaires (300) les uns par rapport aux autres comprennent des éléments mâles (323) prévus sur l'une des bordures longitudinales du fond (304) qui viennent s'emboîter dans des éléments femelles (322) prévus sur l'autre bordure longitudinale du fond (304).

17. Structure selon l'une des revendications 10 à 16, caractérisée en ce que les susdits côtés latéraux (302) de l'élément cellulaire (300) sont raccordés aux bordures latérales du flan (301) au moyen de liaisons (305) formant charnières.

18. Structure selon la revendication 17, caractérisée en ce que l'élément cellulaire (300) est réalisé en matière plastique moulée, et en ce que les susdites liaisons formant charnières (305) consistent en des pattes de liaison flexibles venues de moulage ou en des lignes de moindre épaisseur.

19. Structure selon l'une des revendications 17 et 18, caractérisée en ce que le maintien des côtés latéraux (302) des éléments cellulaires perpendiculairement au flan (301) est assuré au moyen d'un dispositif d'encliquetage prévu entre le fond (304) et les bordures latérales des côtés latéraux adjacents audit fond (304).

**Patentansprüche**

1. Elektronische Karten tragende zellenförmige Struktur, die durch Zusammenfügen von wenigstens zwei elektronische Karten tragenden und schützenden Modulzellen gebildet wird, dadurch gekennzeichnet, dass besagte Modulzellen jeweils einerseits ein flaches Element oder Plättchen (301) aufweisen, mit zwei parallelen Seitenrändern, einem vorderen und einem hinteren Rand und andererseits, in senkrechter Richtung zu besagtem Plättchen verlaufend und von seinem hinteren Rand und seinen beiden Seitenrändern ausgehend, jeweils einen Bodenteil (304) und zwei Seitenteile (302, 205), die mit Mitteln zur Führung der Karten versehen sind, welche zwei jeweils zum Plättchen (301) parallele Seitenführungen (303) bilden, und dass besagte Seitenteile (302) der Modulzelle jeweils einen ersten, besagtem Plättchen benachbarten, Längsrand aufweisen und einen zweiten, dem ersten gegenüberliegenden Längsrand, wobei besagte Längsränder jeweils einander ergänzende Befestigungsmittel (207, 211) aufweisen, um zwei benachbarte Modulzellen durch zusammenfügen der ersten Längsränder der Seitenteile (302, 205) der ersten Zelle mit den zweiten Längsrändern der Seitenteile der zweiten Modulzelle zu befestigen.

2. Struktur nach Anspruch 1, dadurch gekennzeichnet, dass sie ausserdem eine vordere Basis (110) aufweist, mit mindestens einer ebenen Fläche, die mit Befestigungsmitteln (116) versehen ist, welche die auf besagten zweiten Längsrändern der Seitenteile (302, 205) der Modulzellen vorgesehenen ergänzen.

3. Struktur nach Anspruch 2, dadurch gekennzeichnet, dass besagte vordere Basis (110) aus einen Gehäuse besteht, welches elektronische Ausrüstungsteile enthalten kann, die an die in den Modulzellen angeordneten Karten angeschlossen werden können.

4. Struktur nach Anspruch 2, dadurch gekennzeichnet, dass die besagte Basis eine ebene Wand (111) aufweist, die mit zwei parallelen Seitenrändern versehen ist, einem vorderen und einem hinteren Rand und andererseits, senkrecht zu besagter Wand (111) verlaufend und von ihrem hinteren Rand und ihren beiden Seitenrändern ausgehend, einen Bodenteil (114) und zwei Seitenteile (112, 113), und dass die Seitenränder der besagten Seitenteile der Basis (112, 113), welche besagter Wand (111) gegenüberliegen, mit Befestigungsmitteln (116) versehen sind, welche die auf besagtem zweiten Rand der Seitenteile (302, 205) der Modulzellen vorgesehenen (207) ergänzen.

5. Struktur nach einem der vorhergehenden Ansprüche, dadurch gekennzeichnet, dass der Bodenteil (306) der besagten Modulzellen mindestens ein Durchgangsfenster (312) für einen hinteren Verbinder (600) aufweist, der in die hinteren Verbindungen der Karte eingesteckt werden kann.

6. Struktur nach Anspruch 5, dadurch gekennzeichnet, dass die Hinterseite des Bodenteils der besagten Modulzellen mit dem Fenster (312) fluchtende Auflageflächen für die entsprechenden Seiten des Verbinders (600) aufweist, sowie Mittel, um besagten Verbinder (600) in seiner Lage festzuhalten.

7. Struktur nach einem der Ansprüche 5 und 6, dadurch gekennzeichnet, dass die Breite und die Höhe der im Bodenteil (304) angebrachten Durchgangsfenster (312, 118) die des hinteren Verbinders (600) übertrifft und dass besagte Festhaltemittel so ausgelegt sind, dass sie den Verbinder (600) seitlich festhalten, wenn dieser in die Karte (400) eingesteckt worden ist.

8. Struktur nach einem der Ansprüche 6 und 7, dadurch gekennzeichnet, dass besagte Festhaltemittel von einer biegsamen Drucklamelle (700) gebildet werden, die in eine Behausung mit bogenförmigem Ausschnitt (319, 320) der Hinterseite der Zelle eingeführt werden kann.

9. Struktur nach einem der Ansprüche 5 bis 8, dadurch gekennzeichnet, dass die hinteren Verbinder (600) auf den gleichen mehradrigen flachen Bus (601) montiert sind, wobei der Montageabstand der Verbinder auf dem Bus den Maximalabstand der Karten in benachbarten Zellen übersteigt.

10. Struktur nach einem der vorhergehenden Ansprüche, dadurch gekennzeichnet, dass besagte Modulzellen (130) aus zwei Teilen bestehen, nämlich :

- einem ersten Teil, der aus einem Zellelement (300) aus Isoliermaterial besteht, mit dem flachen Element oder Plättchen (301), welches die beiden parallelen Seitenränder, den vorderen und den hinteren Rand aufweist und andererseits, senkrecht zu besagtem Plättchen verlaufend und von seinem hinteren Rand und seinen beiden Seitenrändern ausgehend, dem Bodenteil (304) und den beiden Seitenteilen (302), die mit Kartenführungsmitteln versehen sind, welche zwei jeweils zum Plättchen (301) parallele seitliche Führungen (303) bilden und einer Metallabschirmung (200) mit U-förmigem Querschnitt, dessen zentraler Teil (201) mindestens das Plättchen (301) des Zellelementes (300) überdeckt und dessen zwei Schenkel (205) über die besagten beiden Seitenflächen (302) reichen.

11. Struktur nach Anspruch 10, dadurch gekennzeichnet, dass die Befestigungsmittel (207, 211), welche auf den Seitenteilen der Modulzelle angebracht sind, auf den Schenkeln (205) der Abschirmung (200) vorgesehen sind und die elektrische Verbindung zwischen besagten Abschirmungen (200) herstellen.

12. Struktur nach einem der Ansprüche 10 und 11, dadurch gekennzeichnet, dass die freien Ränder der Schenkel (205) der Abschirmung (200) nach innen gebogene Abschnitte (210) aufweisen, damit das Zellelement durch Einschieben in der Abschirmung angeordnet werden kann.

13. Struktur nach einem der Ansprüche 10 bis 12, dadurch gekennzeichnet, dass besagte Befestigungsmittel aus Haken (207) bestehen, welche von den freien Rändern der Schenkel (205) der Abschirmung (200) abstehen und aus entsprechenden, in der Biegungszone zwischen dem Zentralteil (201) und den Schenkeln (205) der besagten Abschirmung angeordneten Ausschnitten (211), sodass die Haken (207) einer Modulzelle in die Ausschnitte einer benachbarten axial verschobenen Modulzelle eingreifen können und die Verriegelung dann durch eine axiale Zentrierverschiebung einer der Zellen im Verhältnis zur anderen vorgenommen wird.

14. Struktur nach einem der Ansprüche 10 bis 13, dadurch gekennzeichnet, dass besagte Modulzellen ausserdem Mittel zur Zentrierung der Zellenelemente (300) im Verhältnis zueinander aufweisen, sowie Mittel zur Selbstzentrierung der Zellenelemente (300) in ihren jeweiligen Abschirmungen (200).

15. Struktur nach Anspruch 14, dadurch gekennzeichnet, dass die Mittel zur Selbstzentrierung der Zellelemente (300) in ihren jeweiligen Abschirmungen (200) Öffnungen (203, 204) aufweisen, welche Eingriffspunkte für Sperrklinken (311) bilden, die an entsprechenden Stellen auf dem Plättchen des Zellelementes vorgesehen sind.

16. Struktur nach Anspruch 14, dadurch gekennzeichnet, dass die Mittel zur Zentrierung der Zellelemente (300) im Verhältnis zueinander auf einem der Längsränder des Bodenteils (304) vorgesehene männliche Elemente (323) aufweisen, die in auf dem anderen Längsrand des Bodenteils (304) vorgesehene weibliche Elemente (322) eingreifen.

17. Struktur nach einem der Ansprüche 10 bis 16, dadurch gekennzeichnet, dass besagte Seitenteile (302) des Zellelementes (300) mit den Seitenrändern des Plättchens (301) durch ein Scharnier bildende Mittel (305) verbunden sind.

18. Struktur nach Anspruch 17, dadurch gekennzeichnet, dass das Zellelement (300) aus geformtem Plastikmaterial hergestellt ist und die besagten Scharniere bildenden Mittel (305) aus biegsamen angeformten Verbindungslaschen und Linien geringerer Stärke bestehen.

19. Struktur nach einem der Ansprüche 17 und 18, dadurch gekennzeichnet, dass die Seitenteile (302) der Zellelemente senkrecht zum Plättchen (301) gehalten werden, durch eine zwischen dem Bodenteil (304) und den Seitenrändern der besagtem Bodenteil (304) benachbarten Seitenteile vorgesehene Sperrvorrichtung.

**Claims**

1. An electronic card holding cell-like structure formed by assembling together at least two modular electronic card supporting and protecting cells, characterized in that said modular cells each comprise, on the one hand, a flat element or blank (301) having two parallel lateral edge portions, a front edge portion and a rear edge portion and, on the other hand, extending perpendicularly to said blank, from its rear edge portion and from its two lateral edge portions respectively, a bottom (304) and two lateral sides (302, 205) having guide means for the cards forming two respective lateral slides (303) parallel to the blank (301) and in that said lateral sides (302) of the modular cell each comprise a first longitudinal edge portion adjacent said blank and a second lontigudinal edge portion opposite the first one, these two longitudinal edge portions comprising respectively complementary fixing means (207, 211) so as to allow fixing of two adjacent modular cells by assembly of the first longitudinal edge portions of the lateral sides (302, 205) of the first cell on the second longitudinal edge portions of the lateral sides of the second modular cell.

2. The structure as claimed in claim 1, characterized in that it further comprises a head base (110) comprising at least one flat face equipped with fixing means (116) complementary to those provided on said second longitudinal edge portions of the lateral sides (302, 205) of the modular cells.

3. The structure as claimed in claim 2, characterized in that said head base (110) consists of a case which may contain electronic equipments connectable to the cards housed in the modular cells.

4. The structure as claimed in claim 2, characterized in that said base comprises a flat wall (111) having two parallel lateral edge portions, a front edge portion and a rear edge portion and, on the other hand, extending perpendicularly to said wall (111), from its rear edge portion and from its two side edge portions, respectively a bottom (114) and two lateral sides (112, 113) and in that said lateral edge portions of said lateral sides of the base (112, 113) which are opposite said wall (111) are provided with fixing means (116) complementary to those (207) provided on said second edge portion of the lateral sides (302, 205) of the modular cells.

5. The structure as claimed in one of the preceding claims, characterized in that the bottom (306) of said modular cells has at least one window (312) for passing therethrough a rear connector (600) pluggable into the rear connections of the card.

6. The structure as claimed in claim 5, characterized in that the rear face of the bottom of said modular cells has, at right angles to the window (312), bearing surfaces for corresponding faces of the connector (600) as well as means for immobilizing said connector (600).

7. The structure as claimed in one of claims 5 and 6, characterized in that said passage windows (312, 118) formed in the bottom (304) have a width and a height greater than those of the rear connectors (600) and said immobilizing means are adapted for laterally immobilizing the conn-ector (600) once it is plugged into the card (400).

8. The structure as claimed in one of claims 6 and 7, characterized in that said immobilizing means are formed by a resilient pressure plate (700) adapted to be engaged in an indented housing (319, 320) in the rear face of the cell.

9. The structure as claimed in one of claims 5 to 8, characterized in that said rear connectors (600) are mounted in the same flat multiconductor bus (601), the mounting pitch of the connectors on the bus being greater than the maximum pitch of the cards of the adjacent cells.

10. The structure as claimed in one of the preceding claims, characterized in that said modular cells (130) are formed in two parts, namely
- a first part consisting of a cellular element (300) made from an insulating material comprising the flat element or blank (301) having the two parallel lateral edge portions, the front edge portion and the rear edge portion and, on the other hand, extending perpendicularly to said blank from its rear edge portion and from its two side edge portions respectively, the bottom (304) and the two lateral sides (302) having means for guiding the cards forming the two respective lateral slides (303) parallel to the blank (301), and
- a metal shield (200) having a O-shaped section whose web (201) is adapted at least to cover the blank (301) of the cellular element (300) and whose two wings (205) come back against said two lateral sides (302).

11. The structure as claimed in claim 10, characterized in that the fixing means (207, 211) equipping the lateral sides of the modular cell are provided on the wings (205) of the shield (200) and ensure the electrical connection between said shields (200).

12. The structure as claimed in one of the claims 10 and 11, characterized in that the free edge portions of the wings (205) of the shield (200) comprise portions folded back inwardly (210) so as to allow the cellular element to be fitted by sliding inside the shield.

13. The structure as claimed in one of claims 10 to 12, characterized in that said fixing means consist of hooks (207) projecting form the free edges of the wings (205) of the shield (200) and from corresponding cut-outs (211) provided in the bending zone situated between the web (201) and the wings (205) of said shield, so that the hooks (207) of one modular cell may be engaged in the cut-outs of an adjacent modular cell offset axially, locking then, being provided by axial centering translation of one of the cells with respect to the other.

14. The structure as claimed in one of claims 10 to 13, characterized in that said modular cells further comprise means for centering the cellular elements (300) with respect to each other as well as means allowing self-centering of the cellular elements (300) in their respective shields (200).

15. The structure as claimed in claim 14, characterized in that the means allowing self-centering of the cellular elements (300) in their respective shields (200) comprise openings (203, 204) forming latches for catches (311) provided in corresponding positions on the blank of the cellular element.

16. The structure as claimed in claim 14, characterized in that the means allowing centering of the cellular elements (300) with respect to each other comprise male elements (323) on one of the longitudinal edge portions of the bottom (304) which fit into female elements (322) on the other longitudinal edge portion of the bottom (304).

17. The structure as claimed in one of claims 10 to 16, characterized in that said lateral sides (302) of said cellular element (300) are connected to the lateral edge portions of the blank (301) by means of hinge connections (305).

18. The structure as claimed in claim 17, characterized in that said cellular element (300) is made from a molded plastic material and in that said hinge connections (305) consist of integrally molded flexible connecting lugs or lines of lesser thickness.

19. The structure as claimed in one of claims 17 and 18, characterized in that the lateral sides (302) of the cellular elements are held perpendicularly to the blank (301) by means of a snap-fit device provided between the bottom (304) and the lateral edge portions of the lateral sides adjacent said bottom (304).

FIG.1

FIG.2

FIG.3

FIG.4

FIG.5

FIG. 6

FIG. 7

FIG. 8

FIG. 9

FIG. 10

FIG. 11